Europäisches Patentamt

European Patent Office

Office européen des brevets

(19)

(11) Veröffentlichungsnummer : **0 122 946**
**B1**

(12) **EUROPÄISCHE PATENTSCHRIFT**

(45) Veröffentlichungstag der Patentschrift :
09.09.87

(51) Int. Cl.⁴ : **G 06 F   7/50**, H 03 K  19/21

(21) Anmeldenummer : 83103653.8

(22) Anmeldetag : 15.04.83

(54) CMOS-Volladdierstufe.

(43) Veröffentlichungstag der Anmeldung :
31.10.84 Patentblatt 84/44

(45) Bekanntmachung des Hinweises auf die Patenterteilung : 09.09.87 Patentblatt 87/37

(84) Benannte Vertragsstaaten :
DE FR GB IT NL

(56) Entgegenhaltungen :
EP-A- 0 048 352
FR-A- 2 516 675
US-A- 3 767 906
US-A- 3 932 734
US-A- 4 039 858
NATIONAL TECHNICAL REPORT, Band 22, Nr. 5,
Oktober 1976, Seiten 601-606, Asaka (JP). T. KYO-
GOKU et al.: "CMOS high-speed full-adder for microprocessors"
IBM TECHNICAL DISCLOSURE BULLETIN, Band 25,
Nr. 5, Oktober 1982, Seiten 2377-2379, New York
(USA). Z. T. DEARDEN et al.: "Eight-Device exclusive
or CMOS circuit"
IBM TECHNICAL DISCLOSURE BULLETIN, Band 25,
Nr. 5, Oktober 1982, Seiten 2375-2376, New York
(USA). Z. T. DEARDEN et al.: "Four-device exclusive
or CMOS circuit"

(73) Patentinhaber : **Deutsche ITT Industries GmbH**
**Hans-Bunte-Strasse 19 Postfach 840**
**D-7800 Freiburg (DE)**
**DE**
**ITT INDUSTRIES INC.**
**320 Park Avenue**
**New York, NY 10022 (US)**
**FR GB IT NL**

(72) Erfinder : **Uhlenhoff, Arnold, Dipl.-Ing.**
**Hölderlinstrasse 33**
**D-7830 Emmendingen (DE)**

(74) Vertreter : **Morstadt, Volker, Dipl.-Ing.**
**c/o Deutsche ITT Industries GmbH Patent/Lizenzab-**
**teilung Postfach 840 Hans-Bunte-Strasse 19**
**D-7800 Freiburg/Brsg. (DE)**

## Beschreibung

Die Erfindung betrifft eine CMOS-Volladdierstufe, also eine in komplementärer Isolierschicht-Feldeffekttransistor-Technik realisierte Volladdierstufe.

Die Gesamtheit der Merkmale des Oberbegriffs des Anspruchs 1 ist aus der US-A 37 67 906, insbesondere Fig. 1 bekannt. Dabei liegt zwischen Übertragseingang und Übertragsausgang ein weiteres Transmission-Gate. Diese Volladdierstufe ist also vom sogenannten Switched-Carry-Typ, vgl. zu diesem Typ die EP-A 48 352, wonach im Übertragsweg für das Übertragssignal höchstens ein Gatter angeordnet sein soll. Dieses ist erforderlich, da bei alleinigem Vorhandensein eines Transfertransistors im Übertrag-Signalweg diese bei Aufbau eines Paralleladdierers miteinander direkt in Serie geschaltet wären und dies dazu führte, daß das Übertragssignal schon nach wenigen Stufen an zur sicheren Pegelerkennung ausreichender Amplitude verloren hätte. Dieser Sachverhalt ist nicht nur bei Addierern, die wie die der EP-A 48 352 aus MOS-Transistoren ein und desselben Leitungstyps (Ein-Kanal-Schaltung) aufgebaut sind, anzutreffen, sondern allgemein bei MOS-Schaltungen, also auch bei CMOS-Schaltungen, bei denen der Transfer-Transistor durch ein Transmission-Gate ersetzt ist.

Die Erfindung betrifft daher keine Switched-Carry-Addierstufe, sondern eine(n) Ripple-Carry-Addierer (stufe). Bei diesem Addierertyp wird das Übertragssignal einer vorausgehenden Stufe zusammen mit dem Addiersignal der betroffenen Stufe in ihr logisch verknüpft und aus diesen drei Signalen das Summen- und das (neue) Übertragssignal gebildet, vgl. die EP-A 48 821, die ebenfalls wie die genannte EP-A 48 352 eine Ein-Kanal-Schaltung für einen Paralleladdierer betrifft.

Die Aufgabe der in den Ansprüchen gekennzeichneten Erfindung besteht darin, eine CMOS-Volladdierstufe des Ripple-Carry-Typs mit besonders schneller Übertragsbildungszeit anzugeben.

Aus der US-A 40 39 858 ist das bei der Abwandlung der Erfindung nach Anspruch 2 verwendete EXNOR-Gatter aus vier Transistoren bekannt, aus dem ohne weiteres durch Vertauschung der an die beiden Teileingänge anzulegenden Addiersignalteile das bei der Erfindung verwendete EXOR-Gatter mit vier Transistoren hervorgeht.

Die Erfindung wird nun anhand der Figuren der Zeichnung näher erläutert.

Figur 1 zeigt das Schaltbild des verwendeten EXORs und das zugehörige, im weiteren verwendete Schaltsymbol,

Figur 2 zeigt das Schaltbild des verwendeten EXNORs mit zugehörigem Schaltsymbol,

Figur 3 zeigt in Schaltsymboldarstellung eine CMOS-Volladdierstufe nach der Erfindung,

Figur 4 zeigt in Schaltsymboldarstellung die erwähnte Abwandlung der Erfindung als zweite CMOS-Volladdierstufe,

Figur 5 zeigt das ausführliche Schaltbild der CMOS-Volladdierstufe nach Fig. 3, und

Figur 6 zeigt das ausführliche Schaltbild der CMOS-Volladdierstufe nach Fig. 4.

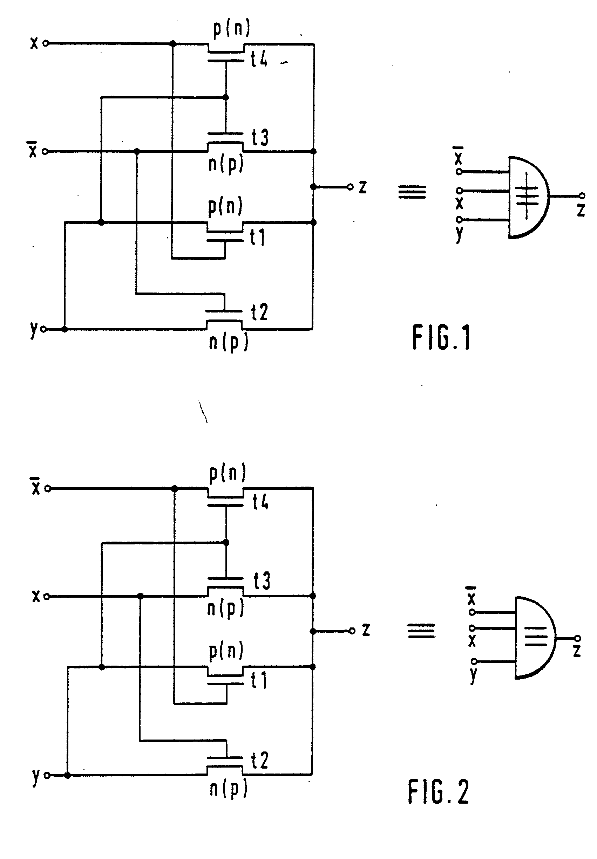

Das EXOR- und das EXNOR-Gatter, die mittelbar bzw. unmittelbar aus dem Stand der Technik bekannt sind, haben die Eigenschaft, daß ihr erster Eingang in den ersten Teileingang x und den zweiten Teileingang x̄ aufgeteilt ist, an welche beiden Teileingänge jeweils das nichtinvertierte bzw. das invertierte eine Addiersignal anzulegen ist, während der zweite Eingang y für das andere Addiersignal ungeteilt ist, wobei es an ihm in nichtinvertierter Form anzulegen ist. Bei den in den Fig. 1 bis 4 verwendeten Schaltsymbolen kommt diese Eigenschaft dadurch zeichnerisch zum Ausruck, daß die beiden Teileingänge x, x̄ näher beieinander gezeichnet sind als der Teileingang x und der zweite Eingang y.

Das EXOR bzw. EXNOR besteht jeweils aus den vier Transistoren t1, t2, t3, t4, wovon die beiden Transistoren t1, t4, vom einen Leitungstyp sind ; in Fig. 1 sind sie als p-leitend angenommen, wobei durch den Buchstaben in der Klammer angedeutet ist, daß sie auch n-leitend sein können. Die beiden Transistoren t2, t3 sind vom anderen Leitungstyp ; in Fig. 1 sind sie demnach als n-leitend angenommen, wobei das p in der Klammer wiederum andeutet, daß auch p-Leitung möglich ist.

Das Gate des vierten Transistors t4 liegt am zweiten Eingang y und der ausgangsabgewandte Pol der Source-Drain-Strecke dieses Transistors t4 beim EXOR am ersten Teileingang x bzw. am EXNOR am zweiten Teileingang x̄. Das Gate des ersten Transistors t1 ist mit dem ausgangs-abgewandten Pol der Source-Drain-Strecke des vierten Transistors t4 verbunden. Der ausgangsabgewandte Pol der Source-Drain-Strecke des ersten Transistors t1 liegt am zweiten Eingang y. Der ausgangsabgewandte Pol der Source-Drain-Strecke des dritten Transistors t3 liegt beim EXOR am zweiten Teileingang x̄.

Die Source-Drain-Srecken aller vier Transistoren t1... t4 liegen gemeinsam am Gatterausgang z. Das Gate des ersten Transistors t1 ist beim EXOR am ersten Teileingang x bzw. beim EXNOR am zweiten Teileingang x̄ angeschlossen. Das Gate des zweiten Transistors liegt beim EXOR am zweiten Teileingang x̄ bzw. beim EXNOR am ersten Teileingang x. Das Gate des dritten Transistors t3 und das des vierten Transistors t4 ist sowohl beim EXOR als auch beim EXNOR mit dem zweiten Eingang y verbunden.

Der jeweils ausgangsabgewandte Pol der Source-Drain-Strecken des ersten und des zweiten Transistors t1, t2 liegt am zweiten Eingang y, während der entsprechende Pol des dritten Transistors t3 beim EXOR am zweiten Teileigang x̄ bzw. beim EXNOR am ersten Teileingang x angeschlossen ist. Schließlich ist der entsprechende Pol des vierten Transistors t4 beim EXOR mit dem ersten Teileingang x bzw. beim EXNOR mit dem zweiten Teileingang x̄ verbunden.

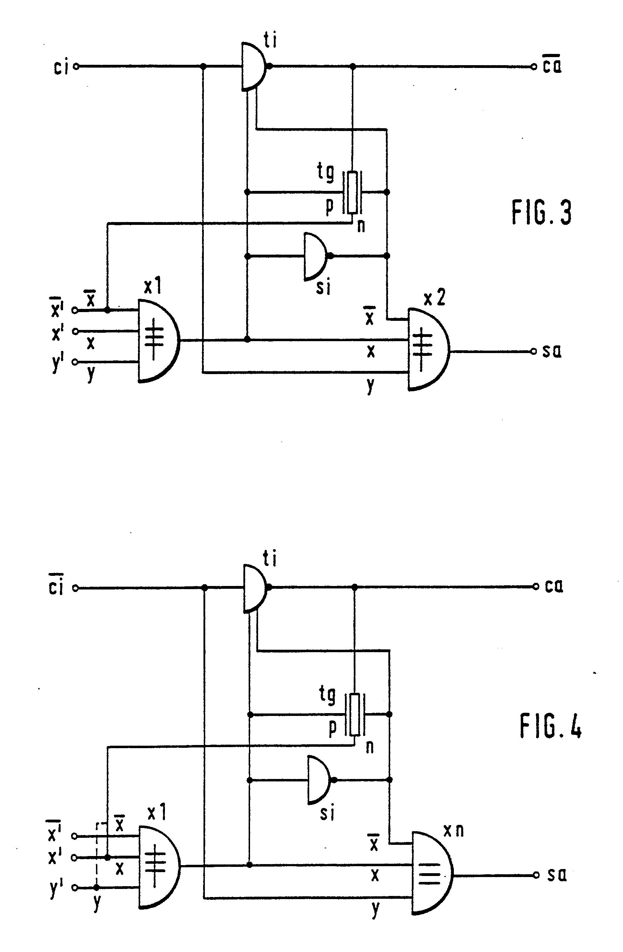

Die Fig. 3 betrifft eine Volladdierstufe nach der Erfindung, bei der der Übertragseingang ci für ein nichtinvertiertes Übertrag-Eingangssignal vorgesehen ist und am Übertragsausgang ca ein entsprechend invertiertes Übertrag-Ausgangssignal auftritt. Bei der Fig. 4 sind diese beiden Teilmerkmale vertauscht, d. h. der Übertragseingang ci ist für ein invertiertes Übertrag-Eingangssignal vorgesehen, und am Übertragsausgang ca entsteht ein nichtinvertiertes Übertrag-Ausgangssignal.

Die beiden zu beschreibenden Volladdierstufen unterscheiden sich dadurch voneinander, daß diejenige nach Fig. 3 zwei erfindungsgemäße EXORS x1, x2 verwendet, während bei der Stufe nach Fig. 4 das EXOR x2 durch das EXNOR xn ersetzt ist. Da die Eingänge des ersten EXORs x1 zugleich die Eingänge der jeweiligen Volladdierstufe sind, ist deren erster Eingang ebenfalls in die beiden Teileingänge x' und x̄ aufgeteilt, während der zweite Eingang y' ungeteilt ist. Dabei ist selbstverständlich, daß diesen Eingängen, da sie identisch sind mit dem ersten bzw. zweiten Teileingang x, x̄ des EXNORs, das entsprechende nicht invertierte bzw. invertierte erste Addiersignal zuzuführen ist, während an den zweiten Eingang y' das zweite Addiersignal in nichtinvertierter Form anzulegen ist.

Der erste Teileingang x des zweiten EXORs x2 (Fig. 3) bzw. des EXNORs xn (Fig. 4) liegt am Ausgang des ersten EXORs x1, während der Übertragseingang ci bzw. c̄i am zweiten Eingang y des zweiten EXORs x2 bzw. des EXNORs angeschlossen ist. Der entsprechende Übertragseingang ci, c̄i liegt über den getakteten Inverter ti am entsprechenden Übertragsausgang c̄a (Fig. 3), ca (Fig. 4).

Der Ausgang des ersten EXORs x1 liegt ferner am Eingang des statischen Inverters si, am ersten Takteingang des getakteten Inverters ti und am ersten Takteingang des Transmission-Gates tg, an dessen zweitem Takteingang zusammen mit dem zweiten Takteingang des getakteten Inverters ti der Ausgang des statischen Inverters si angeschlossen ist. Für die in den Figuren 1 und 2 außerhalb der Klammer angegebenen Leitungsarten der vier Transistoren t1... t4 ist der in den Figuren 3 und 4 links liegende Transistor des Transmission-Gates tg von der einen Leitungsart, also p-leitend, und der rechts gezeichnete von der anderen Leitungsart, also n-leitend.

Die Schaltstrecke des Transmission-Gates tg liegt bei der Volladdierstufe nach Fig. 3 zwischen dem zweiten Teileingang x̄' und dem Übertragsausgang c̄a, dagegen bei der Volladdierstufe nach Fig. 4 zwischen dem ersten Teileingang x' oder dem zweiten Eingang y', was dort durch die gestrichelte Verbindungslinie angedeutet ist, um dem Übertragsausgang ca. In Fig. 3 ist der Ausgang des zweiten EXORs x2 der Summenausgang sa, während dies in Fig. 4 der Ausgang des EXNORs xn ist.

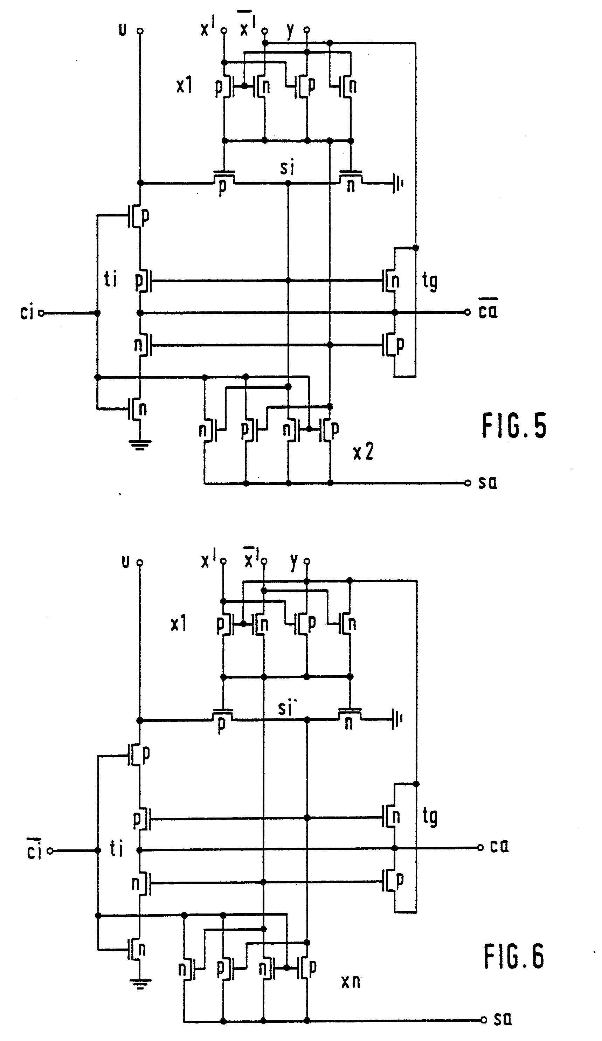

Die Figur 5 bzw. 6 zeigt das in Transistoren ausgeführte Schaltbild der Anordnungen nach Figur 3 bzw. 4. Der Übersichtlichkeit halber sind bei den EX(N)ORs x1, x2, xn die Bezugszeichen für die einzelnen Transistoren weggelassen. Da die Schaltungen durch die Zwischenverbindungen und die Eingangs-Bezeichnungen ausreichend klar sind, ist dies auch nicht erforderlich. Aus den Figuren 5, 6 ist ersichtlich, daß der getaktete Inverter ti aus der Reihenschaltung von vier Transistoren besteht, wovon jeweils die « oberen » zwei benachbarten vom einen und die « unteren » zwei benachbarten vom anderen Leitungstyp sind, deren gesteuerte Strompfade insgesamt in Serie zwischen dem Schaltungsnullpunkt und der Betriebsspannung u liegen. Dabei sind die beiden am Schaltungsnullpunkt und an der Betriebsspannung u liegenden Transistoren durch ihre Gateverbindung die eigentlichen Invertertransistoren, während die beiden « innenliegenden » Transistoren die der Zuführung des ersten bzw. zweiten Taktsignals dienenden Transistoren sind.

An der Betriebsspannung u und dem Schaltungsnullpunkt liegt ferner der statische Inverter si, der wie üblich aus zwei mit ihren gesteuerten Strompfaden in Serie liegenden Transistoren entgegengesetzten Leitungstyps besteht, die in Serie zwischen dem Schaltungsnullpunkt und der Betriebsspannung u liegen. Das Transmission-Gate tg besteht wie üblich ebenfalls aus zwei Transistoren entgegengesetzten Leitungstyps, deren gesteuerte Strompfade parallelgeschaltet sind.

Wie ersichtlich ist, besteht jede der beiden Volladdierstufen der Figuren 5 und 6 aus jeweils sechzehn Transistoren, wovon die eine Hälfte vom einen und die andere Hälfte vom anderen Leitungstyp ist, d. h. die Schaltung ist bezüglich des Leitungstyps auch anzahlsymmetrisch.

Werden eine Volladdierstufe nach Fig. 5 und eine nach Fig. 6 hinsichtlich des Übertrag-Signalwegs in Reihe geschaltet, und schließt sich an die Schaltung nach Fig. 6 wiederum eine nach Fig. 5 und so fort an, so ergibt sich ein CMOS-Paralleladdierer, bei dem pro Stufe im Übertrag-Signalweg jeweils nur ein einziger Inverter liegt. Dadurch ist ein derartiger Volladdierer vom Typ des sogenannten Ripple-Carry-Addierers, der hinsichtlich der Übertragsbildungszeit besonders schnell ist.

**Patentansprüche**

1. CMOS-Volladdierstufe.

— mit einem ersten und einem zweiten Eingang (y') für ein erstes und ein zweites Addiersignal und mit einem Übertragseingang (ci) für ein nichtinvertiertes Übertrag-Eingangssignal,

— mit einem ersten Exklusiv-ODER-Gatter (= EXOR) (x1), an dessen erstem Eingang das erste Addiersignal und an dessen zweitem Eingang (y) das zweite Addiersignal liegt,

— mit einem zweiten EXOR (x2), dessen erster Eingang am Ausgang des ersten EXORs (x1) und dessen zweiter Eingang (y) am Übertragseingang (ci) liegt sowie dessen Ausgang der Summenausgang (sa) ist,

— mit einem statischen Inverter (si), dessen Eingang am Ausgang des ersten EXORs (x1) angeschlossen ist, und

— mit einem Transmission-Gate (tg), dessen erster Takteingang am Ausgang des ersten EXORs (x1), dessen zweiter Takteingang am Ausgang des statischen Inverters (si), welcher Ausgang der Übertragsausgang (ca) ist, und dessen Schaltstrecke zwischen ihm und dem ersten Eingang des ersten EXORs (x1) liegen, gekennzeichnet durch folgende Merkmale :

— jedes EXOR (x1, x2) hat einen ersten Teileingang (x) und einen zugehörigen zweiten Teileingang (x̄), an welche beiden Teileingänge jeweils das nichtinvertierte bzw. das invertierte eine Addiersignal anzulegen ist, wobei dem zweiten Eingang (y) das andere Addiersignal in nichtinvertierter Form zuzuführen ist, und besteht

— aus einem ersten Transistor (t1) des einen Leitungstyps, dessen Gate am ersten Teileingang (x) und dessen ausgangsabgewandter Pol seiner Source-Drain-Strecke am zweiten Eingang (y) liegen,

— aus einem zweiten Transistor (t2), dessen Gate am zweiten Teileingang (x̄) und dessen ausgangsabgewandter Pol seiner Source-Drain-Strecke am zweiten Eingang (y) liegen,

— aus einem dritten Transistor (t3) des anderen Leitungstyps, dessen Gate am zweiten Eingang (y) und dessen ausgangsabgewandter Pol seiner Source-Drain-Strecke am zweiten Teileingang (x̄) angeschlossen ist, und

— aus einem vierten Transistor (t4) des einen Leitungstyps, dessen Gate am zweiten Eingang (y) und dessen ausgangsabgewandter Pol seiner Source-Drain-Strecke am ersten Teileingang (x) liegt, wobei,

— jeweils die Source-Drain-Strecke der vier Transistoren (t1 ... t4) am Gatterausgang (z) liegt,

— der erste Teileingang (x) des zweiten EXORs (x2) liegt am Ausgang des ersten EXORs (x1),

— der Signaleingang eines getakteten Inverters (ti) ist mit dem Übertragseingang (ci) verbunden,

— der erste Takteingang des getakteten Inverters (ti) liegt am Ausgang des ersten EXORs (x1) und der. zweite Takteingang am Ausgang des statischen Inverters (si),

— der Ausgang des getakteten Inverters (ti) ist am Übertragsausgang (ca) angeschlossen,

— die Schaltstrecke des Transmission-Gates (tg) liegt zwischen dem zweiten Teileingang (x̄) des ersten EXORs (x1) und dem Übertragsausgang (ca), und

— der Ausgang des statischen Inverters (si) liegt auch am zweiten Teileingang (x̄) des zweiten EXORs (x2).

2. Abwandlung der CMOS-Volladdierstufe nach Anspruch 1, wobei der übertragsausgangabgewandte Pol der Schaltstrecke des Transmission-Gates (tg) am ersten Teileingang (x) des ersten EXORs (x1) liegt und das zweite EXOR (x2) durch Vertauschung seines ersten (x) mit seinem zweiten Teileingang (x̄) als Exklusiv-NOR-Gatter (= EXNOR) (xn) wirkt.

3. CMOS-Paralleladdierer mit CMOS-Volladdierstufen nach den Ansprüchen 1 und 2, dadurch gekennzeichnet, das bezüglich der Übertragseingang- bzw. Übertragsausgangs-Strecke abwechselnd Stufen nach Anspruch 1 bzw. 2 in Serie geschaltet sind.

**Claims**

1. CMOS full-adder stage having

— a first input for a first signal to be added, a second input (y') for a second signal to be added, and a carry input (ci) for an uninverted carry input signal,

— a first exclusive-OR gate (= EXOR) (x1) whose first input and second input (y) are supplied with first and second signals to be added, respectively,

— a second EXOR (x2) whose first input and second input (y) are connected to the output of the first EXOR (x1) and to the carry input (ci), respectively, and whose output is the sum output (sa),

— a static inverter (si) having its input connected to the output of the first EXOR (x1), and

— a transmission gate (tg) having its first clock input connected to the output of the first EXOR (x1), and its second clock input to the output of the static inverter (si), which output is the carry output (ca), and having its switching path connected between the carry output (ca) and the first input of the first EXOR (x1), characterized by the following features :

— Each EXOR (x1, x2) has a first sub-input (x) of a first input and an associated second sub-input (x̄) to which two sub-inputs one of the signals to be added has to be applied in uninverted form and in inverted form, respectively, the other signal to be added having to be applied to the second input (y) in univerted form, and consists of

— a first transistor (t1) of one conductivity type whose gate is connected to the first sub-input (x), and whose channel terminal not connected to the output is connected to the second input (y),

— a second transistor (t2), whose gate is connected to the second sub-input (x̄), and whose channel terminal not connected to the output is connected to the second input (y),

— a third transistor (t3) which is of the other conductivity type and whose gate is connected to the second input (y), while its channel terminal not connected to the output is connected to the second sub-input (x̄), and

— a fourth transistor (t4), which is of said one conductivity type and whose gate is connected to the second input (y), while its channel terminal not connected to the output is connected to the first sub-input (x),

— with the channels of the four transistors (t1 ... t4) connected to the gate output (z) ;

— the first sub-input (x) of the second EXOR (x2) is connected to the output of the first EXOR (x1) ;

— the signal input of a clocked inverter (ti) is connected to the carry input (ci) ;

— the first clock input of the clocked inverter (ti) is connected to the output of the first EXOR (x1), and the second clock input to the output of the static inverter (si) ;

— the output of the clocked inverter (ti) is connected to the carry output (ca) ;

— the switching path of the transmission gate (tg) is connected between the second sub-input ($\bar{x}$) of the first EXOR (x1) and the carry output (ca), and

— the output of the static inverter (si) is also coupled to the second sub-input ($\bar{x}$) of the second EXOR (x2).

2. Modification of the CMOS full-adder stage claimed in claim 1, wherein that terminal of the switching path of the transmission gate (tg) not connected to the carry output is connected to the first sub-input (x) of the first EXOR (x1), and wherein the first sub-input (x) and the second sub-input ($\bar{x}$) of the second EXOR (x2) are interchanged, so that the second EXOR (x2) acts an exclusive-NOR gate (= EXNOR) (xn).

3. CMOS parallel adder with CMOS full-adder stages as claimed in claims 1 and 2, characterized in that stages as claimed in claims 1 and 2 are alternately connected in series with respect to the carry-input and carry-output paths, respectively.

**Revendications**

1. Etage additionneur complet CMOS comprenant :

— une première et une deuxième entrée (y') pour un premier et un deuxième signal d'addition et une entrée de report (ci) pour un signal d'entrée de report non inversé,

— une première porte OU-exclusif (EXOR) (x1), à la première entrée de laquelle est appliqué le premier signal d'addition et la deuxième entrée (y) de laquelle est appliqué le deuxième signal d'addition,

— une deuxième porte EXOR (x2) dont la première entrée est couplée à la sortie de la première porte EXOR (x1) et dont la deuxième entrée (y) est couplée à l'entrée de report (ci), de sorte que sa sortie est la sortie de somme (sa),

— un inverseur statique (si) dont l'entrée est reliée à la sortie de la première porte EXOR (x1) et

— une porte de transmission (tg) dont la première entrée de commande est couplée à la sortie de la première porte EXOR (x1), dont la deuxième entrée de commande est couplée à la sortie de l'inverseur statique (si), dont la sortie est couplée à la sortie de report (ca), et dont le trajet commuté est connecté entre celle-ci et la première entrée de la première porte EXOR (x1), caractérisé en ce que :

— chaque porte EXOR (x1, x2) comporte une première entrée partielle (x) et une deuxième entrée partielle associée ($\bar{x}$), à chacune de ces deux entrées partielles étant respectivement fournis un signal d'addition non inversé et ce signal d'addition inversé, alors que la deuxième entrée (y) reçoit l'autre signal d'addition sous la forme non inversée, et se compose de :

— un premier transistor (t1) d'un premier type de conductibilité, dont la grille est couplée à la première entrée partielle (x) et dont la borne opposée à la sortie de son trajet source-drain est couplée à la deuxième entrée (y),

— un deuxième transistor (t2) dont la grille est couplée à la deuxième entrée partielle ($\bar{x}$) et dont la borne opposée à la sortie de son trajet source-drain est connectée à la deuxième entrée (y),

— un troisième transistor (t3) de l'autre type de conductibilité, dont la grille est couplée à la deuxième entrée (y) et dont la borne opposée à la sortie de son trajet source-drain est couplée à la deuxième entrée partielle ($\bar{x}$), et

— un quatrième transistor (t4) du premier type de conductibilité, dont la grille est couplée à la deuxième entrée (y) et dont la borne opposée à la sortie de son trajet source-drain est couplée à la première entrée partielle, de sorte que

— chacun des trajets source-drain des quatre transistors (t1 ... t4) est connecté à la sortie de la porte (z),

— la première entrée partielle de la deuxième prote EXOR (x2) est couplée à la sortie de la première porte EXOR (x1),

— l'entrée de signal d'un inverseur commandé (ti) est connectée à l'entrée de report (ci),

— la première entrée de commande de l'inverseur commandé (ti) est couplée à la sortie de la première porte EXOR et sa deuxième entrée de commande à la sortie de l'inverseur statique (si),

— la sortie de l'inverseur commandé (ti) est reliée à la sortie de report (ca),

— le trajet de commutation de la porte de transmission (tg) est connecté entre la deuxième entrée partielle ($\bar{x}$) de la première porte EXOR (x1) et la sortie de report (ca), et

— la sortie de l'inverseur statique (si) est aussi couplée à la deuxième entrée partielle ($\bar{x}$) de la deuxième porte EXOR (x2).

2. Variante de l'étage additionneur complet CMOS de la revendication 1, dans laquelle la borne opposée à la sortie de report du trajet commuté de la porte de transmission (tg) est couplée à la première entrée partielle (x) de la première porte EXOR (x1) et la deuxième porte EXOR (x2) par permutation de sa première entrée partielle (x) avec sa deuxième entrée partielle ($\bar{x}$), se comporte en porte NON-OU exclusif (EXNOR) (xn).

3. Additionneur parallèle CMOS à étages additionneurs complets CMOS selon la revendication 1 ou 2, caractérisé en ce que des étages selon les revendications 1 et 2 respectivement sont alternativement montées en série, en ce qui concerne leurs trajets entrée de report à sortie de report.

FIG.1

FIG.2

1

**0 122 946**

FIG. 3

FIG. 4

**0 122 946**

FIG.5

FIG.6